(19) Europäisches Patentamt
European Patent Office
Office européen des brevets

(11) Numéro de publication : **0 289 393 B1**

(12) **FASCICULE DE BREVET EUROPEEN**

(45) Date de publication du fascicule du brevet :
28.08.91 Bulletin 91/35

(21) Numéro de dépôt : 88400951.5

(22) Date de dépôt : 20.04.88

(51) Int. Cl.⁵ : **C30B 11/00, B22D 27/04**

(54) **Four de coulée de pièces à structure orientée, à écran thermique déplaçable.**

(30) Priorité : 23.04.87 FR 8705713

(43) Date de publication de la demande :
02.11.88 Bulletin 88/44

(45) Mention de la délivrance du brevet :
28.08.91 Bulletin 91/35

(84) Etats contractants désignés :
CH DE FR GB IT LI SE

(56) Documents cités :
EP-A- 0 177 132
FR-A- 2 255 950
US-A- 3 714 977
PATENT ABSTRACTS OF JAPAN, vol. 10, no.
49 (C-330)(/2106), 26 février 1986, page 103 C
330; & JP-A-60 195 087 (HAMAMATSU HOTO-
NIKUSU K.K.) 03-10-1985

(73) Titulaire : **SOCIETE NATIONALE D'ETUDE ET
DE CONSTRUCTION DE MOTEURS
D'AVIATION, "S.N.E.C.M.A."**
**2, Boulevard du Général Martial Valin**
**F-75015 Paris (FR)**

(72) Inventeur : **Lallement, Bernard Louis**
**24, rue de Lorraine**
**F-92300 Levallois-Perret (FR)**

(74) Mandataire : **Moinat, François et al**
**S.N.E.C.M.A. Service des Brevets Boîte
Postale 81**
**F-91003 Evry Cédex (FR)**

**Description**

La présente invention concerne un four adapté à la coulée de pièces métalliques moulées, notamment en superalliages, à structure orientée et comportant un écran thermique entre la zone chaude de la chambre de coulée et la zone froide de la chambre de solidification.

FR-78.19567 (FR-A-2604378) a décrit la disposition d'un tel écran thermique dans un appareillage de fonderie ainsi que ses fonctions d'isolation thermique entre le four et le refroidisseur tout en permettant le passage du moule.

US-A-3714977 décrit un appareillage adapté à la coulée de pièces à structure orientée dans lequel un écran thermique fixe est placé à la base du dispositif de chauffage et un écran entourant le moule et adapté sur la plaque-support refroidie suit le déplacement de l'ensemble mobile jusqu'au contact avec l'écran fixe qui le retient pendant que ce déplacement se poursuit.

Ces dispositions connues antérieures laissent subsister le problème d'une isolation thermique insuffisante lorsque le moule présente des évolutions géométriques d'un plan à l'autre perpendiculaires à la direction du déplacement en cours de solidification. Il en résulte des variations et en particulier des abaissements du gradient thermique qui ont pour conséquence des variations également et en particulier un accroissement de la taille de structure dendritique primaire sur les pièces obtenues. De telles structures ont des effets néfastes sur les propriétés mécaniques des pièces et rendent la mise en oeuvre des traitements thermiques ultérieurs plus délicate et moins aisée à réaliser.

L'invention permet de résoudre ces difficultés et d'éviter ces inconvénients. Un four du genre précité est caractérisé en ce que l'écran d'isolation thermique est constitué d'au moins deux secteurs associés à des moyens susceptibles de les déplacer, pendant une opération de solidification de pièces, en translation dans le plan de l'écran, selon une direction perpendiculaire à la direction de déplacement du moule.

Avantageusement, chaque secteur d'écran est formé d'une partie rigide, éloignée du moule, formant le support d'une partie constituée en un matériau réfractaire souple dont le contour est proche de celui du moule.

Avantageusement, le déplacement de chaque secteur est commandé par un vérin asservi au dispositif de commande du four, notamment aux déplacements du moule en cours de solidification.

D'autres caractéristiques et avantages de l'invention seront mieux compris à l'aide de la description qui va suivre d'un mode de réalisation de l'invention, en référence aux dessins annexés sur lesquels :

— la figure 1 représente une vue schématique partielle en coupe axiale d'un four équipé d'un écran d'isolation thermique conforme à l'invention ;

— la figure 2 représente une vue en section transversale du four représenté à la figure 1 et montre l'écran d'isolation thermique et son système de commande de déplacement.

— les figures 3a, 3b, 3c représentent schématiquement des exemples de réalisation de pièces, respectivement, en 3a avec la mise en oeuvre d'un écran d'un genre précédemment connu, en 3b et 3c avec la mise en oeuvre d'un écran d'isolation thermique déplaçable, conforme à l'invention.

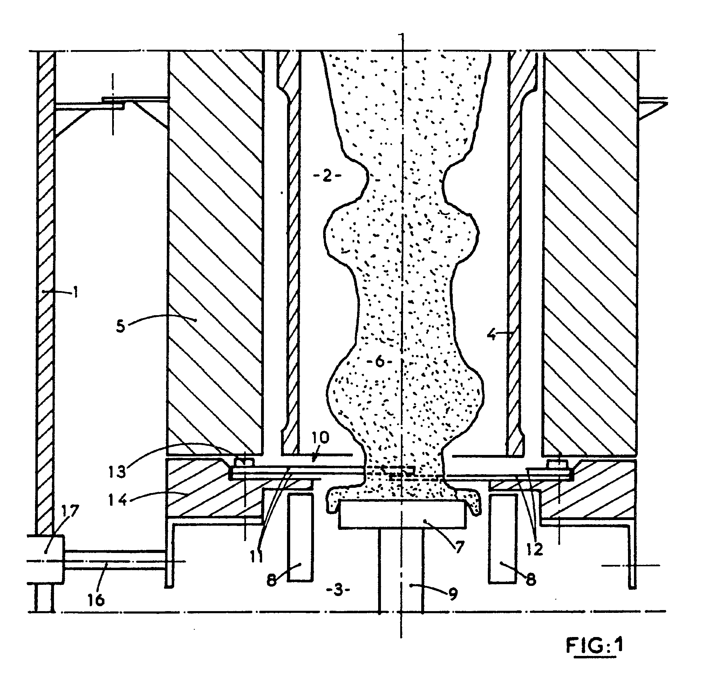

Une partie d'un four adapté à la coulée de pièces métalliques moulées, notamment en superalliages, à structure orientée est représentée en coupe axiale à la figure 1. 1 désigne la paroi extérieure du four ; la partie supérieure 2 constitue la chambre de coulée proprement dite et la partie inférieure 3 constitue la chambre de solidification. La chambre de coulée 2 est garnie intérieurement d'éléments chauffants 4 d'un type connu, formant un resistor. Entre la paroi extérieure 1 et lesdits éléments chauffants 4, sont placés des éléments d'isolation thermique 5. Un moule 6 a été représenté à l'intérieur du four. Le moule 6 est placé sur une sole horizontale 7 qui comporte des éléments refroidisseurs et d'autres éléments refroidisseurs 8 sont placés radialement à l'extérieur de ladite sole 7. La sole 7 est portée par un support 9 qui se déplace à l'intérieur de la chambre de solidification 3 dans laquelle le moule se déplace, provoquant la solidification de la (ou des) pièce(s) coulée(s).

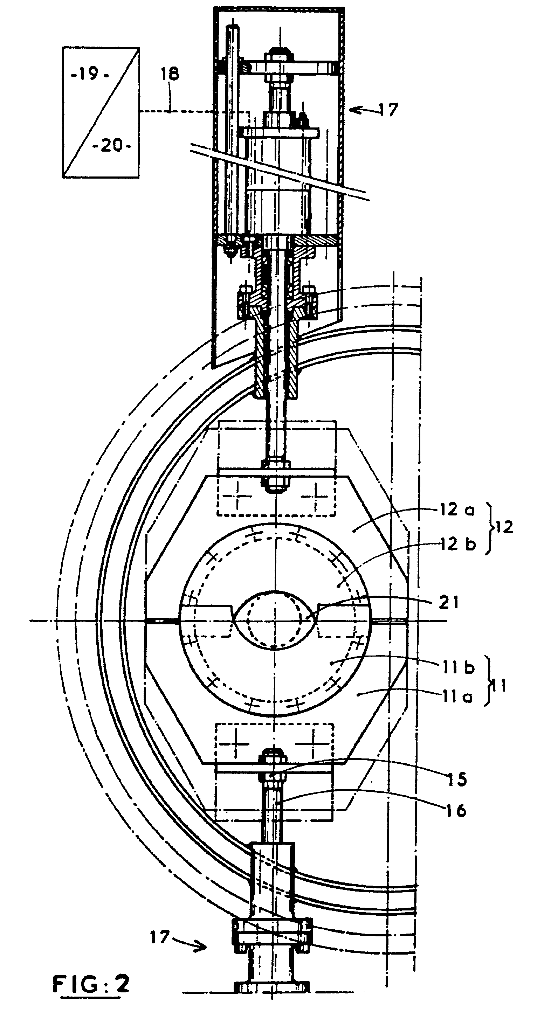

Entre la chambre de coulée 2 et la chambre de solidification 3 et séparant les éléments chauffants 4 des éléments refroidisseurs 8 et 7, est placé un écran 10 d'isolation thermique dont certains détails de réalisation sont également visibles sur la figure 2 et qui fait l'objet de la présente invention. L'écran 10 qui présente un contour extérieur circulaire ou polygonal, comme dans l'exemple représenté, est divisé en secteurs, au nombre de deux, 11 et 12 dans l'exemple représenté, de manière à ménager une ouverture 21 en son centre, pour le passage du moule 6. Chaque secteur est fixé, par exemple au moyen de vis telles que 13, sur un élément support 14. Chaque secteur est constitué d'une première partie, telle que 11a et 12a, constituant la partie radialement externe de l'écran 10 la plus éloignée du moule 6, en un matériau réfractaire rigide d'un genre connu et formant le support d'une deuxième partie. Ladite deuxième partie, telle que 11b et 12b, constitue la partie radialement interne de l'écran 10, en un matériau souple réfractaire ou isolant thermique d'un genre connu qui recouvre la première partie 11a et 12a respectivement. Le contour radialement interne desdits secteurs souples 11b et 12b est découpé à la demande, de manière à suivre de près le contour externe du moule 6 utilisé. Autour dudit moule 6, les secteurs 11b et 12b chevauchent en se recouvrant partiellement, de manière à assurer une isolation thermique améliorée.

A la figure 2, on a représenté des moyens assurant le déplacement des secteurs 11, 12 dans le plan de l'écran 10 d'isolation thermique, en translation selon une direction perpendiculaire à la direction de déplacement du moule 6. On obtient de cette manière une adaptation précise du contour du bord interne des secteurs 11, 12 au contour externe du moule 6. L'extrémité 15 d'une tige 16 d'un vérin 17 est fixée sur chaque élément support 14 d'un secteur 11, respectivement 12.

Chaque vérin 17 est piloté par une liaison 18 d'asservissement au dispositif 19 de commande du four et en particulier au dispositif 20 qui commande le déplacement du support 9 portant la sole 7 et le moule 6. De cette manière, au cours de l'opération de solidification des pièces, le contour interne des secteurs 11, 12 de l'écran 10 d'isolation thermique est ajusté au plus près au contour externe du moule 6.

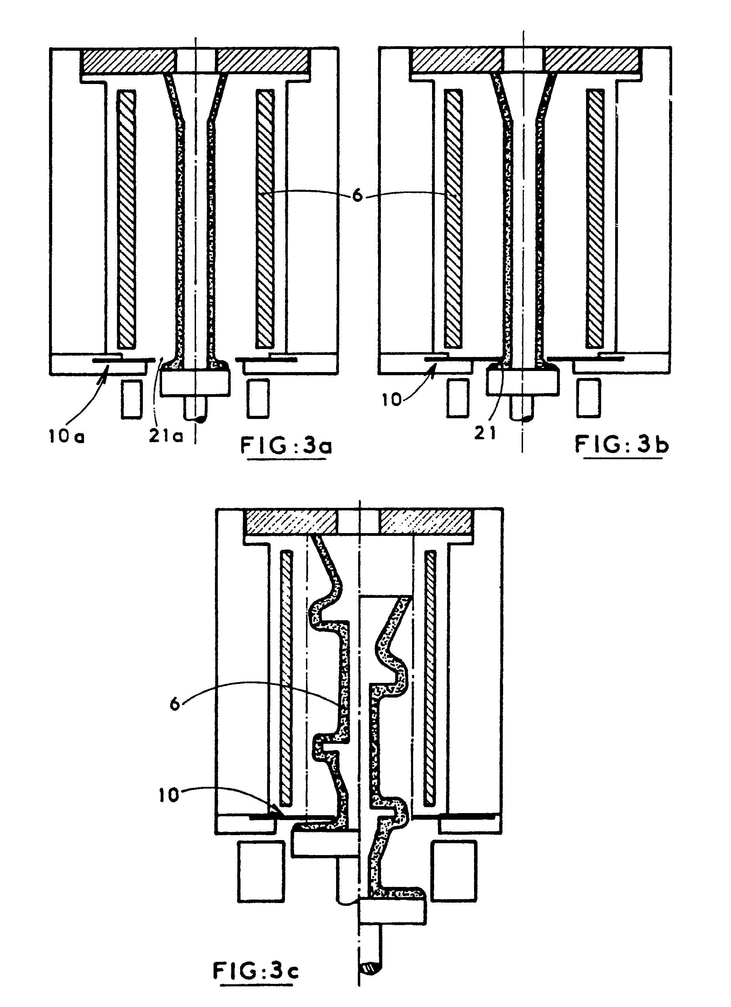

La figure 3a schématise un exemple de mise en oeuvre d'un four comportant un écran 10a qui reste immobile et fixe au cours de l'opération de solidification d'une pièce, selon les techniques antérieurs connues. L'écran 10a présente par conséquent dans ce cas une ouverture centrale 21a qui doit être au moins égale à la section transversale maximale que présente le moule 6a. Dans cette réalisation, on a observé une évolution de la taille de structure dendritique primaire qui varie entre une valeur de 280μm à 40 mm du bas du moule et une valeur de 350 μm en haut.

La figure 3b schématise un exemple de mise en oeuvre similaire à celui de la figure 3a. Mais dans cet exemple, au contraire, l'écran 10 est conforme à l'invention et son ouverture centrale 21 peut être ajustée à la section correspondante du moule 6, par le mode de réalisation de l'écran 10 et les moyens de commande de déplacement horizontal qui ont été décrits précédemment. Il en est résulté une taille de structure dendritique primaire d'une valeur de 230 μm qui est inférieure à celle qui était obtenue en référence à la figure 3a et qui, en outre, est constante sur la même longueur considérée.

Ces résultats montrent l'efficacité des dispositions conformes à l'invention et leur apport intéressant pour résoudre les problèmes posés par la mise en oeuvre de la solidification orientée des pièces, notamment en superalliages et notamment pour la solidification monocristalline, en permettant d'obtenir des structures fines et constantes.

La figure 3c schématise un exemple de mise en oeuvre similaire à celui de la figure 3b montrant que divers programmes de variation de la position des secteurs de l'écran 10 d'isolation thermique doivent être adaptés en fonction du profil des moules 6 utilisés.

## Revendications

1. Four adapté à la coulée de pièces métalliques moulées, notamment en superalliages, à structure orientée, comportant un écran (10) d'isolation thermique de forme générale plate entre la zone chaude de la chambre de coulée (2) et la zone froide de la chambre de solidification (3), ledit écran permettant le passage du moule caractérisé en ce que ledit écran (10) est constitué d'au moins deux secteurs (11, 12) associés à des moyens (14, 17) susceptibles de les déplacer, pendant une opération de solidification de pièce(s), en translation dans le plan de l'écran, selon une direction perpendiculaire à la direction de déplacement du moule (6).

2. Four selon la revendication 1 dans lequel chaque secteur (11, 12) de l'écran (10) d'isolation thermique est formé d'une partie rigide (11a, 12a), éloignée du moule, formant le support d'une partie (11b, 12b) constituée en un matériau réfractaire souple dont le contour est proche de celui du moule.

3. Four selon la revendication 2 dans lequel les parties (11b, 12b) d'écran (10) d'isolation thermique en matériau réfractaire souple présentent des zones en recouvrement entre secteurs.

4. Four selon l'une quelconque des revendications 1 à 3 dans lequel le déplacement de chaque secteur (11, 12) d'écran (10) est commandé par un vérin (17).

5. Four selon la revendication 4 dans lequel une liaison d'asservissement (18) est disposée entre lesdits vérins (17) et le dispositif de commande (19) du four, notamment le dispositif (20) commandant le déplacement du moule (6) en cours de solidification.

## Patentansprüche

1. Ofen zum Gießen von Metallgußwerkstücken, insbesondere von Metallgußwerkstücken aus Superlegierungen, mit einem bestimmten Gefüge, mit einem Wärmeschutzschirm von im wesentlichen flacher Form zwischen der heißen Zone der Gießkammer (2) und der kalten Zone der Verfestigungskammer (3), wobei dieser Wärmeschutzschirm den Durchgang der Gußform erlaubt, **dadurch gekennzeichnet,** daß der Wärmeschutzschirm (10) aus wenigstens zwei Sektoren (11, 12) besteht, denen Mittel (14, 17) zugeordnet sind, mit deren Hilfe sie während der Verfestigung des Werkstücks bzw. der Werkstücke in einer Translationsbewegung in der Ebene des Wärmeschutzschirms in einer senkrecht zur Bewegungsrichtung der Gußform (6) bewegt werden können.

2. Ofen nach Anspruch 1, bei dem jeder Sektor (11, 12) des Wärmeschutzschirms (10) aus einem von der Gußform entfernten starren Teil (11a, 12a) gebildet ist, das den Träger eines Teils (11b, 12b) darstellt, das aus einem weichen wärmefesten Werkstoff besteht und dessen Form an die Gestalt der Gußform angenähert ist.

3. Ofen nach Anspruch 2, bei dem die aus weichem wärmefestem Werkstoff bestehenden Teile (11b, 12b) des Wärmeschutzschirms (10) Überlappungszonen zwischen den Sektoren besitzen.

4. Ofen nach einem der Ansprüche 1 bis 3, bei dem die Verschiebung jedes Sektors (11, 12) des Wärmeschutzschirms (10) durch einen Arbeitszylinder (17) gesteuert wird.

5. Ofen nach Anspruch 4, bei dem zwischen dem genannten Arbeitszylinder (17) und der Steuervorrichtung (19) des Ofens, insbesondere der die Bewegung der Gußform im Verlauf der Verfestigung steuernden Vorrichtung (20), eine Servokopplung (18) vorgesehen ist.

## Claims

1. Furnace suited to the casting in moulds of metallic components, notably in superalloys, with an oriented structure, comprising a heat-insulating screen (10) of generally flat shape, between the hot zone of the casting chamber (2) and the cool zone of the solidification chamber (3), the said screen allowing the mould to pass through it, characterised in that the said screen (10) is made up of at least two segments (11, 12) associated with a means (14, 17) capable of moving them translationally, during the operation of solidification of the part(s), in the plane of the screen, in a direction perpendicular to the direction of movement of the mould (6).

2. Furnace in accordance with Claim 1 in which each segment (11, 12) of the heat-insulating screen (10) is made up of a rigid part (11a, 12a), distant from the mould and forming the support for a second part (11b, 12b) made of a flexible refractory material whose contour is close to that of the mould.

3. Furnace in accordance with Claim 2 in which the parts (11b, 12b) of the heat-insulating screen (10) in a flexible refractory material have areas which overlap the other segment.

4. Furnace in accordance with any of Claims 1 to 3 in which the movement of each segment (11, 12) of the screen (10) is controlled by a ram (17).

5. Furnace in accordance with Claim 4 in which a servo-linkage (18) is placed between the said rams (17) and the furnace control device (19), notably the device (20) controlling the movement of the mould (6) during solidification.

FIG:1

FIG:2

FIG:3a

FIG:3b

FIG:3c